(19) Europäisches Patentamt

European Patent Office

Office européen des brevets

(11) EP 0 811 985 B1

(12) EUROPEAN PATENT SPECIFICATION

(45) Date of publication and mention
of the grant of the patent:
**11.07.2001 Bulletin 2001/28**

(51) Int Cl.7: **G11C 11/407**

(86) International application number:
**PCT/JP95/02658**

(21) Application number: **95941868.2**

(22) Date of filing: **25.12.1995**

(87) International publication number:
**WO 97/23877 (03.07.1997 Gazette 1997/29)**

(54) **IMPROVED SEMICONDUCTOR MEMORY WITH ROW DECODER OUTPUTTING ROW SELECTING SIGNAL**

VERBESSERTER HALBLEITERSPEICHER MIT EINEM ZEILENAUSWAHLSIGNAL AUSGEBENDEM ZEILENDEKODERS

MEMOIRE A SEMICONDUCTEUR AMELIOREE A DECODEUR D'ADRESSE DE LIGNE FOURNISSANT LES SIGNAUX DE SELECTION DE LIGNE

(84) Designated Contracting States:
**DE FR GB NL**

(43) Date of publication of application:
**10.12.1997 Bulletin 1997/50**

(73) Proprietor: **Oki Electric Industry Company,
Limited
Tokyo 105 (JP)**

(72) Inventors:
• **TAKAHASHI, Shinya
Minato-ku, Tokyo 105 (JP)**

• **HONDA, Takashi
Minato-ku, Tokyo 105 (JP)**

(74) Representative: **Betten & Resch
Postfach 10 02 51
80076 München (DE)**

(56) References cited:
**JP-A- 1 140 495**      **JP-A- 2 046 589**
**JP-A- 3 003 190**      **JP-A- 6 060 650**

**Description**

TECHNICAL FIELD

The present invention relates to a semiconductor memory device which secures a reliable timing at which a bit line provided with a data from a memory cell is connected to a data bus.

Particularly, the present invention is suitable for applying to a Dynamic Random Access Memory (DRAM).

BACKGROUND ART

In the field of semiconductor memory devices, various technological improvements have been promoted and proposed from the view point of a high speed operation and high integration.

An example was disclosed in Japanese Patent Publication: JP-A-3165398 published on 17th July, 1991, which aimed at a high speed memory device by improving a column decoder providing a memory cell array with a column selecting signal. Another example was disclosed in the United States patent No. 4,344,005 issued on 10th August, 1982, which devised the method of controlling a column decoder.

However, it is an object of the present invention to provide a semiconductor memory device which can perform a higher speed and more reliable operation by further improving various memory devices which have been proposed and improved.

It is another object of the present invention to provide a semiconductor memory device which does not hinder a high integration and not complicate the manufacturing process, which memory device can be realized by a simple designing.

Another example of a semiconductor memory was disclosed in Japanese patent publication JP-A 62-297540 published on November 27, 1987, wherein a selecting switch SW setting a gate potential at the time of a reading operation below the precharge voltage $V_p$ of data lines D, the inverse of D is discharged to a prescribed potential by the differential amplifying circuit SA of the data lines D, the inverse of D of a low potential side to be conductive thereafter, to read automatically input/output line IO, the inverse of IO signal. Accordingly, as long as the data lines D, the inverse of D are not discharged to the prescribed potential, namely, as long as a fine signal read on the data pair lines D, the inverse of D is not amplified, the selecting switch is not made conductive. The connection of the data lines D, the inverse of D and the input/output line IO, the inverse of IO is not unnecessarily delayed. Thereby, the damage and the erroneous reading of the storing information are prevented to attain the high speed operation.

SUMMARY OF THE INVENTION

The semiconductor memory device equipped with column decoder outputting improved column selecting signals and control method of the same of the present invention is described in independent claim 1. In dependent claims 2 and 3 further features of the first embodiment of the present invention are described. A second embodiment is disclosed in dependent claim 4. Therein, a second inverter is connected between the first inverter and the sense amplifier activating signal supply line.

BRIEF DESCRIPTION OF THE DRAWINGS

Fig. 1 is a circuit diagram typically and partially illustrating a circuit of a semiconductor memory device.
Fig. 2 is a circuit diagram illustrating a configuration of a first type unit decoder applied to a column decoder.
Fig. 3 is a circuit diagram illustrating a configuration of a second type unit decoder applied to a column decoder.
Fig. 4 is a timing chart partially illustrating an outline of operation of the semiconductor memory device shown in Fig. 1.
Fig. 5 is a chart explaining a potential relation between a column selecting signal and a bit line.
Fig. 6 is a chart explaining a potential relation of a bit line, a column line, and a data bus.
Fig. 7 is a chart explaining another potential relation of a bit line, a column line, and a data bus.
Fig. 8 is a chart explaining a setting range of a driving potential.
Fig. 9 is a circuit diagram partially illustrating an example in which a power supply switching circuit is applied to the semiconductor memory device.
Fig. 10 is a circuit diagram partially illustrating an embodiment of the present invention.
Fig. 11 is a circuit diagram partially illustrating still another embodiment of the present invention.

BEST MODE FOR CARRYING OUT THE INVENTION

The drawings used for this description typically illustrate major characteristic parts in order that the present invention will be easily understood.

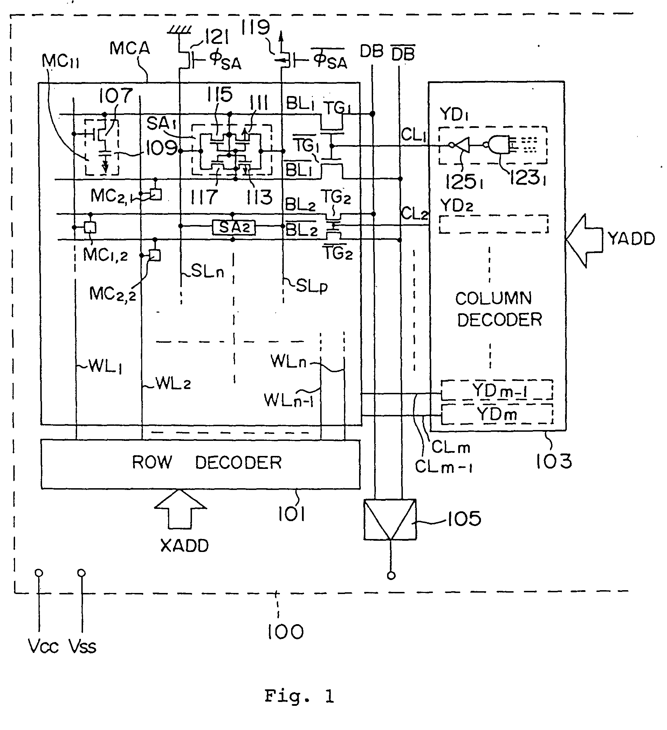

Fig. 1 is a circuit diagram partially illustrating an outline of a semiconductor memory device.
A semiconductor memory device (DRAM) 100 comprises a plurality of memory cells MCi,j (i=1, 2, ··· n, j=1, 2, ··· m) to store data, bit line pairs BL1, $\overline{BL1}$ ~ BLm, $\overline{BLm}$ each connecting to each memory cells, word lines WL1 ~ WLn for transferring row selecting signals that select memory cells, sense amplifiers SA1 ~ SAm for amplifying the potential on each bit line, transfer gate pairs TG1, $\overline{TG1}$, ~ TGm, $\overline{TGm}$ for connecting the bit line pairs to data bus pair DB, $\overline{DB}$ in response to column selecting signals supplied to column lines CL1 ~ CLm, a row decoder 101 for supplying the row selecting signals based on a row address XADD provided from outside, a column decoder 103 for supplying the column selecting signals based on a column address YADD provided from outside, and an input output circuit 105 connected to the data bus pair DB, DB. A power supply potential Vcc and a ground level potential Vss are applied from outside to the memory device 100, and these potentials are used to drive the elements in this memory device. Although the power supply potential Vcc is used to drive the elements in this memory device, it is also known to drive the elements by configuring an internal power supply circuit in this memory device and supplying an internal power supply potential IVcc from the power supply circuit. In replacement of the power supply potential Vcc described in this memory device, the internal power supply potential IVcc can be used, however, since such substitution can be understood with reference to the following description, the description will herein be omitted.

The memory cell MCi, j is formed of an enhancement type N channel MOS transistor (hereinafter referred to as NMOS) 107 and a capacitor 109. The gate electrode of the NMOS 107 is connected to the word line WLi, the drain electrode of the NMOS 107 is connected to the bit line BLj, the source electrode of the NMOS 107 is connected to the capacitor 109, respectively. The capacitor 109 is connected between the source electrode of the NMOS 107 and a reference potential.

The sense amplifier SAi comprises an enhancement type P channel MOS transistors (hereinafter referred to as PMOS) 111 and 113, and NMOSs 115 and 117. The gate electrode of the PMOS 111 is connected to the bit line BLi, the drain electrode of the PMOS 111 is connected to the bit line BLi, and the source electrode of the PMOS 111 is connected to a sense amplifier activating signal supply line SLp, respectively. The gate electrode of the PMOS 113 is connected to the bit line BLi, the drain electrode of the PMOS 113 is connected to the bit line BLi, and the source electrode of the PMOS 113 is connected to the sense amplifier activating signal supply line SLp, respectively.

The gate electrode of the NMOS 115 is connected to the bit line BLi, the drain electrode of the NMOS 115 is connected to the bit line BLi, and the source electrode of the NMOS 115 is connected to a sense amplifier activating signal supply line SLn, respectively. The gate electrode of the NMOS 117 is connected to the bit line BLi, the drain electrode of the NMOS 117 is connected to the bit line BLi, and the source electrode of the NMOS 117 is connected to the sense amplifier activating signal supply line SLn, respectively.

The sense amplifier activating signal supply line SLp, and the sense amplifier activating signal supply line SLn are connected to the power supply potential Vcc and the ground potential Vss through a PMOS 119 and a NMOS 121, respectively. Sense amplifier control signals $\phi$SA and $\overline{\phi SA}$ are supplied to the gate electrodes of the PMOS 119 and NMOS 121, respectively. In response to these control signals, the sense amplifier activating signal supply lines supply the sense amplifier activating signals for activating the sense amplifiers to the sense amplifiers.

This sense amplifier SAi amplifies the potential difference between complementary bit line pairs, BLi and $\overline{BLi}$, during a sensing period (operational period of a sense amplifier) in response to the sense amplifier control signal.

The row decoder 101 decodes the row address XADD supplied from outside and selects the row of the memory cell array MCA. The row decoder 101 supplies the row selecting signal to the word line of the row selected out of the word lines from WL1 to WLm.

The column decoder 103 consists of a plurality of unit column decoders from YD1 to YDm. This column decoder 103 decodes the column address YADD supplied from outside and selects the column of the memory cell array MCA. The column decoder 103 supplies the column selecting signal to the column line of the column selected out of the column lines from CL1 to CLm. The unit column decoder YDi is connected to the column line CLi through an inverter 125i which receives the output from a NAND gate 123i, and controls the transfer gates TGi and $\overline{TGi}$.

The transfer gates TGi, $\overline{TGi}$ are connected between the data bus DB, DB and the bit line BLi, $\overline{BLi}$, respectively, and transfers the data on the bit line BLi, $\overline{BLi}$ to the data bus DBi, $\overline{DBi}$ in response to the column selecting signal. The transfer gate TGi, $\overline{TGi}$ are formed of NMOSs and the gate electrodes are connected to the inverter 125i of the unit column decoder YDi. And, the first electrode of the NMOS TGi is connected to the bit line BLi and the second electrode of NMOS TGi is connected to the data bus DBi. The first electrode of NMOS $\overline{TGi}$ is connected to the bit line $\overline{BLi}$ and the second electrode of the NMOS $\overline{TGi}$ is connected to the data bus $\overline{DB}$.

The data bus DBi, $\overline{DBi}$ are connected between the transfer gate and the input output circuit 105 so as to transfer data therebetween.

The input output circuit 105 receives and distributes data between the memory cell array MCA and the external circuit (not illustrated).

Next, the configuration of the unit decoder YDi of the column decoder 103 will be described more in detail. Since the column decoder 103 consists of a plurality of unit decoders, only the configuration of the unit decoder YDi will be shown typically. The configuration of the other unit decoders and the total configuration of the column decoder will become apparent and easy to understand with reference to the following description.

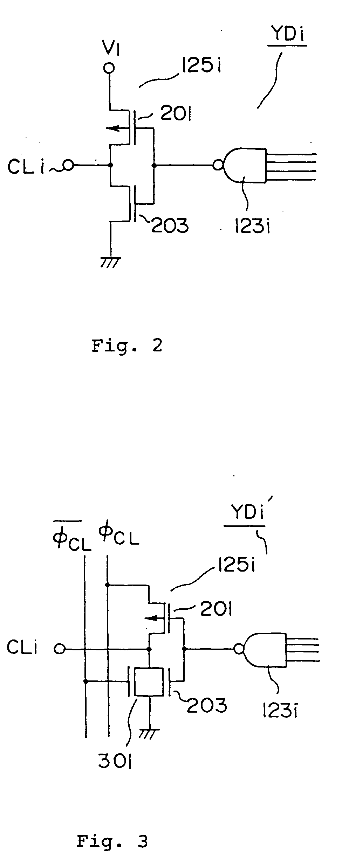

Fig. 2 illustrates a first type unit decoder. The inverter 125i of this unit decoder YDi is formed of a PMOS 201 and a NMOS 203, whose input is connected to the output of the NAND gate 123i, whose output is connected to the column line CLi. The ground potential is applied to one electrode of the NMOS 203, a driving potential V1 which is lower than the power supply potential Vcc is applied to one electrode of the PMOS 201. Since the application of this driving potential V1 is a characteristic part of the present invention, this point will be described more in detail hereafter.

Fig. 3 illustrates a second type unit decoder. In this unit decoder YDi', a NMOS 301 is connected in parallel to the NMOS 203 of the inverter 125i. Further, a column decoder control signal φCL is supplied to one electrode of the PMOS 201, a column decoder control signal $\overline{\phi CL}$, the inverted signal of the column decoder control signal φCL, is supplied to the gate electrode of the NMOS 301. The column decoder 103 is controlled by the column decoder control signals φCL, $\overline{\phi CL}$.

Although the first type unit decoder is applied in the column decoder 103 of the semiconductor memory device illustrated in the foregoing Fig. 1, the first type unit decoder can be easily replaced by the second type unit decoder.

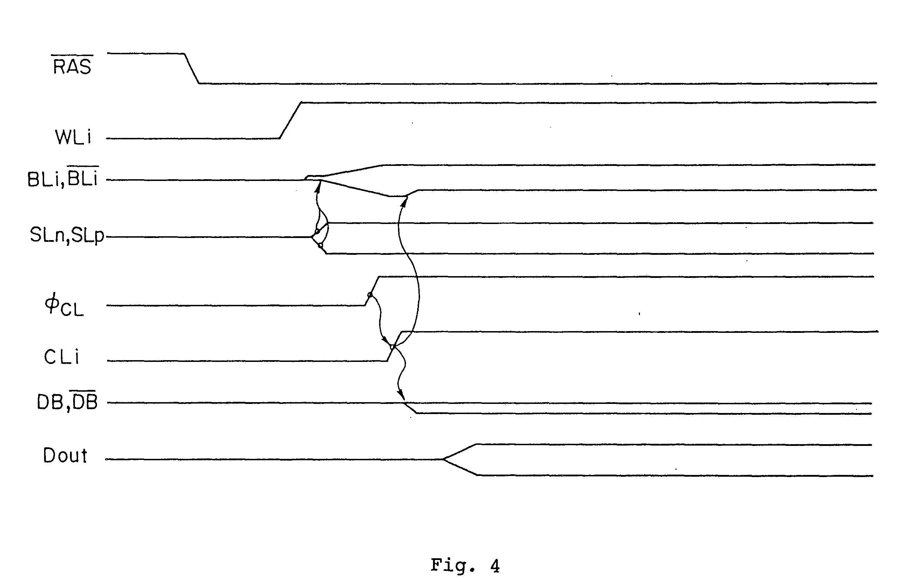

Here, the outline of total operation of the semiconductor memory device illustrated in Fig. 1 will be described briefly with reference to the timing chart shown in Fig. 4. The detailed description of the operation relating to the column decoder that forms a characteristic part of the present invention will be omitted herein for an easy understanding of the present invention. The omitted part in this description will be clearly understood with reference to the descriptions, described later. In Fig. 4, a timing chart is illustrated in a case where the foregoing second type unit decoder is applied, however, the basic operation is substantially the same as a case where the foregoing first type unit decoder is applied. In that case, assumption of a timing chart excluding the waveform of the column control signal φCL in this timing chart will lead to an easy understanding of the operation of the semiconductor memory to which the first type unit decoder is applied.

First, when a Row Address Strobe (RAS) signal supplied to the semiconductor memory device from outside becomes a Low level, the semiconductor memory device is activated. Next, the row decoder 101 decodes the row address XADD supplied from outside and supplies the row selecting signal to the word line WLi of the row selected out of the word lines from WL1 to WLm. And then, the data stored in a memory cell connected to the WLi appears in a potential variation of the bit line pair BLi, $\overline{BLi}$.

Next, When the sense amplifier control signals φSA, $\overline{\phi SA}$ are supplied, the sense amplifier SAi is activated, and the potentials of the bit line pair BLi, $\overline{BLi}$ are amplified. Thereafter, the column decoder control signal φCL is supplied to activate the column decoder 103. The column decoder 103 decodes the column address YADD supplied from outside and supplies the column selecting signal to the column line CLi of the column selected out of the column lines from CL1 to CLm. Consequently, the transfer gates TGi, $\overline{TGi}$ open, and the data bus pair DB, $\overline{DB}$ are connected to the bit line pair BLi, $\overline{BLi}$, leading to transferring the potentials of the bit line pair to the data bus pair. Thereafter, the potentials of the data bus pair DB, $\overline{DB}$ are further amplified by the input output circuit 105, and output as data from an output terminal Dout. Thus, the data stored in the memory cell are read out.

In the foregoing case, although only the data readout operation is described, the data write operation will be omitted herein, since it will be easily understood by persons skilled in the art with reference to the foregoing description of the operation.

Next, the unit decoder will be described which has been suspended so far.

First, as shown in Fig. 2, the potential V1 is applied to one electrode of the PMOS 201 in the inverter 125i of the first unit decoder YDi and is set to a lower potential than the power supply potential Vcc, which will be described with reference to the drawings.

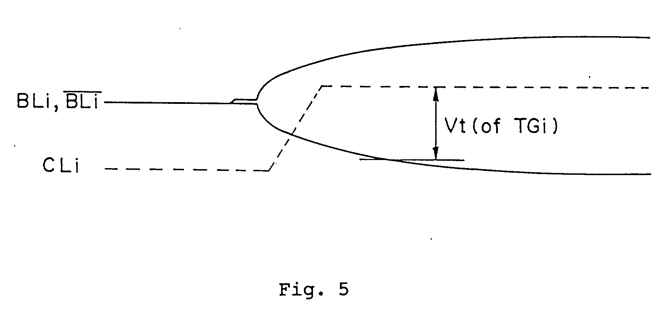

In a DRAM circuit, the driving potential V1 is set as described above, and consequently the potential of the column selecting signal output from the column decoder becomes lower. Therefore, as shown in Fig. 5, even if a column of the memory cell array MCA is selected by the column address YADD and a column selecting signal is supplied to the column line CLi of the column, the transfer gate will not turn on until one of the potential of the bit line BLi or $\overline{BLi}$ (bit lines are precharged to half of the power supply potential Vcc, HVcc) which is to be amplified to a Low level becomes lower than the potential V1 of the column selecting signal by the threshold voltage Vt of transistors forming the transfer gate TGi, $\overline{TGi}$.

In other words, the transfer gate in the semiconductor memory device does not turn on at the timing when the column selecting signal is supplied, but the transfer gate turns on corresponding to the potential of the bit line by monitoring the potential of the bit line. The timing at which the bit line is connected to the data bus is determined by the amplification rate of the potential of the bit line.

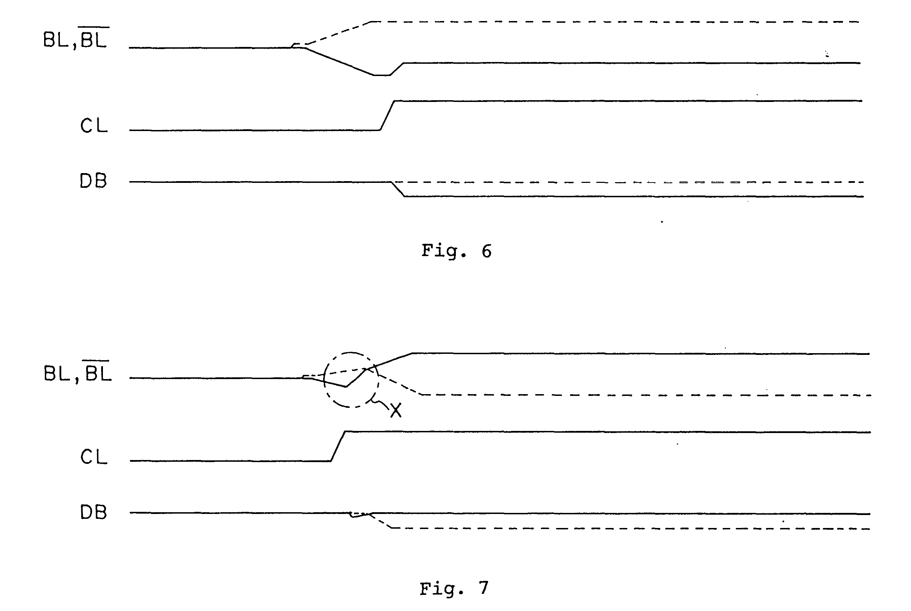

In a general DRAM circuit, when a column selecting signal is supplied to a transfer gate through a column line, the transfer gate immediately turns on and connects a bit line to a data bus as shown in Fig. 6. In this case, the bit line and data bus are precharged in a general precharging method.

In developing a DRAM circuit, it is conceivable to connect a bit line to a data bus before the bit line is sufficiently amplified, that is, while the amplifying operation is in progress, in order to pursue a higher access speed. However, since the parasitic capacity of the data bus is from several times to some tenfold larger than that of the bit line, if the bit line is connected to the data bus before the amplifying operation of the bit line becomes complete, magnitudous charges will flow in the bit line from the data bus, and it is possible that the data on the bit line is destroyed as shown in Fig. 7 (see X part). This will be a hindrance to developing a high-speed DRAM.

Whereupon, if the timing at which the column selecting signal is supplied and the timing at which the bit line is connected to the data bus are to be controlled by any means, the reliability of control will be predictably lowered by the nonuniformity of the process in which the memory device is actually fabricated; or if the timing at which the column selecting signal is supplied is set with sufficient margin, it will become an obstacle to a high speed operation; or if a control circuit for controlling the timing is provided at the periphery of the memory cell array, it will be a big obstacle to a high integration. Practically, the area surrounding the memory cell array is extremely dense with circuits, and the layout of the control circuit in such an area will not contribute to a high integration even though it can contribute to a high-speed memory device.

On the other hand, the bit line is connected to the data bus by the amplification rate of the potential of the bit line. In other words, the bit line is automatically connected to the data bus on the basis of the potential monitored on the bit line. Therefore, the timing at which the bit line is connected to the data bus is always kept most suitable. That is, viewing from the connection timing of both the lines, the timing will materialize the highest speed and most reliable performance. Further, this configuration does not additionally need a complicated circuit design and a complicated production process, and it can easily be realized by applying the current design standard of the circuit and the current production process, and hence, it will not impede a high integration.

The driving potential V1 will further be described.

Let it be defined that the ideally amplified potential of the bit line, when the bit line is connected to the data bus, is a potential VB. Then, the transfer gate turns on at the time when the potential of the bit line is amplified from the potential HVcc to the potential VB, by setting the potential of the column selecting signal output the column decoder to the potential "VB + Vt"( Vt: threshold voltage of transistors forming the transfer gate). This means that, when the amplifying operation of the bit line does not reach a sufficient level, the timing at which the transfer gate turns on does not depend on the timing at which the column selecting signal is output from the column decoder to the column line, that is, the timing is determined by the state of the potential substantially monitored on the bit line.

On the other hand, also in the case of the second type unit decoder YDi' shown in Fig. 3, the timing of turning on the transfer gate can easily be understood with reference to the foregoing description. In this case, the column decoder control signal φCL is supplied to one electrode of the PMOS 201 in the inverter 125i. The potential of the column decoder control signal φCL is set to the driving potential V1. Since this type of case is described in the embodiment described later, it will be understood further easily by the follow-on description.

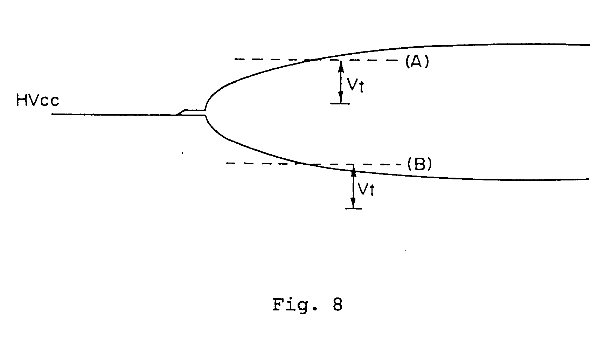

Next, the setting range of the driving potential V1 will be described with reference to Fig. 8. Let it be confirmed that the bit line is precharged to the potential HVcc, half of the power supply potential Vcc, and the threshold voltage of the transistor of the transfer gate is Vt.

First, Fig. 8(A) shows a case where the driving potential V1 is higher than the potential, "HVcc + Vt". In this case, the transistor of the transfer gate turns on regardless of the potential of the bit line so that the foregoing obstacle can not necessarily be avoided. Therefore, the relation "V1 ≤ HVcc + Vt" will be the first condition in setting the driving potential V1. And, Fig. 8(B) shows a case where the driving potential V1 is lower than the potential "HVcc + Vt". In this case, the transistor of the transfer gate always turns off. This will not cause the transfer gate to function as a switch either. Therefore, the relation "V1 ≥ Vt" will be the second condition in setting the driving potential V1.

Therefore, taking these points into consideration, the setting range of the driving potential V1 will be the range satisfying the relation "Vt ≤ V1 ≤ HVcc + Vt". That is, the setting range of the driving potential V1 is lower than the potential (HVcc + Vt) that is higher than the bit line precharged potential HVcc by the threshold voltage Vt of the transistor of the transfer gate, and is higher than the threshold voltage Vt showing the limit where the transfer gate transistor can function as a switch.

The inventor of the present invention discovered the following through experiments relating to the "data destruction on the bit line" as described with reference to Fig. 7 (X part). That is a fact that such data destruction is difficult to occur when the bit line is connected to the data bus after the potential of the bit line is amplified to Vcc/3. In this case, assuming that the amplification rates of the bit line to be amplified toward the High side and the bit line to be amplified toward the Low side of the bit line pair are identical, the following equation will be given;

$$V1 = HVcc - (Vcc/3)/2 + Vt_0$$

Substituting the following values used in the current general DRAM for this equation, the following will be obtained:

(1) when Vcc = 5v, HVcc = 2.5v, Vt =0.8v are given, V1 will be 2.46v, and
(2) when Vcc = 3v, HVcc = 1.5v, Vt = 0.6v are given, V1 will be 1.6v.

Thus, the driving potential V1 in both cases is about half of the external power supply potential Vcc, that is, a potential close to HVcc, which represents an ideal condition.

Setting the driving potential to half of the Vcc, i.e., HVcc, makes it possible to utilize the wirings for supplying half of the Vcc, i.e., HVcc, (wirings for mainly supplying the potential for precharging), laid out in the vicinity of the memory cell array, so that a DRAM circuit can be easily realized which performs a high speed and reliable operation. Thus, by means of a very simple design modification of the current circuit, this high quality DRAM circuit can be easily produced without substantially increasing the manufacturing process. This is an advantage to a manufacturer who makes a huge investment in producing semiconductor memory devices, viewing from the economic aspect.

Next, the improvement of the write operation in which data are written onto the memory cell array will be described, wherein the output potential of this type of column decoder, that is, the potential V1 of the column selecting signal supplied to the column signal line, is set to a potential close to half of the external power supply potential Vcc, i.e., HVcc.

When the driving potential V1 is always set to half of the external power supply potential Vcc, i.e., HVcc, the gate potential of the transistor of the transfer gate becomes HVcc at highest, and hence, the impedance of the bit line and data bus increases, which will be a possible cause to increase the time for a write operation.

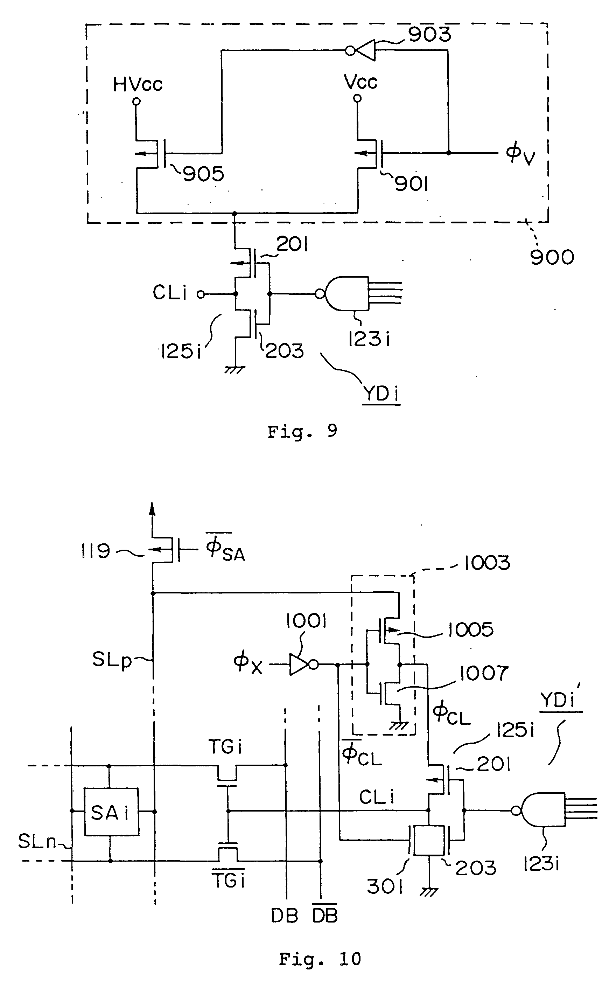

When there seems to be such a possibility, a power supply switching circuit 900 may be disposed on one electrode of the PMOS 201 as shown in Fig. 9.

This power supply switching circuit 900 can switch the power supply by means of a power supply selecting signal φV, and comprises a PMOS 901 to which gate the power supply selecting signal φV is applied and a PMOS 905 to which gate the power supply selecting signal φV is applied via an inverter 903.

One electrode of this PMOS 901 is connected to the power supply potential Vcc, the other electrode is connected to the one electrode of the PMOS 201; wherein when the power supply selecting signal φV is in a Low level, the power supply potential Vcc is supplied to the unit decoder YDi.

One electrode of the PMOS 905 is connected to the potential HVcc, half of the power supply potential Vcc, and the other electrode is connected to the one electrode of the PMOS 201, wherein when the power supply selecting signal φV is in a High level, the power supply potential Vcc is supplied to the unit decoder YDi.

Thus, since the power supply potential Vcc is supplied to the unit decoder YDi in a write operation when the power supply selecting signal φV is changed to a Low level, the output potential of the column decoder will become a power supply potential Vcc level. Further, since half of the power supply potential Vcc, i.e., HVcc is supplied to the unit decoder YDi in a readout operation when the power supply selecting signal φV to a High level, the output potential of the column decoder will become the HVcc, and hence the foregoing characteristic effect can be achieved.

Thus, when there is a possibility to increase the time necessary for a write operation, use of the power switching circuit 900 will remove the factor that may become an obstacle to the high speed operation.

Fig. 9 shows a case to which the first type unit decoder is applied, however, a case to which the second type unit decoder is applied will be understood easily with reference to the foregoing description.

Next, with reference to Fig. 10, an embodiment of the present invention will further be described. In the foregoing described memory device, a high speed operation was achieved by the use of a power supply switching circuit when the write operation time can be assumed to increase. In this embodiment, it is possible to sufficiently receive the merits to be obtained the present invention, however in the foregoing described memory device, it is necessary to control the timing for the power supply selecting signal. However, if the arrangement of the other embodiment, described later, is employed, such a timing control is not needed, and the effect of the present invention can be obtained by a further simplified arrangement. The second type unit decoder is applied in this embodiment, which will be described.

In this embodiment, of an inverter 1001 and 1003 for supplying the unit decoder YDi' with the column decoder control signal φCL, $\overline{\phi CL}$, the inverter 1003 is connected to the sense amplifier activating signal supply line SLp.

A control signal φx is inputted to the inverter 1001, in response to this input, the column decoder control signal $\overline{\phi CL}$ is outputted. This column decoder control signal $\overline{\phi CL}$ is supplied to the input of the inverter 1003 as well as to the gate electrode of a NMOS 301. This inverter 1003 outputs the column control signal φCL in response to the input.

This inverter 1003 comprises a PMOS 1005 and a NMOS 1007. The gate electrodes of the PMOS 1005 and the NMOS 1007 are connected to the input of the inverter, and each one electrode from both is connected to the output of the inverter. The other electrode of the NMOS 1007 is connected to the ground potential Vss. Characteristic is that the other electrode of the PMOS 1005 is connected to the sense amplifier activating supply line SLp. The inverter 1001 is a general type CMOS inverter, and the power supply potential Vcc is supplied to one electrode of the PMOS contained in this inverter.

The circuit operation of this embodiment will be described hereinafter. A better understanding will be obtained with reference to the timing chart in Fig. 4 and the foregoing description.

The sense amplifier activating signal supply line SLp is precharged to the potential Hvcc, half of the power supply potential, in the standby mode of the DRAM described here in the same manner as the case with a general DRAM. Thereafter, the word line is selected, and the row selecting signal is supplied to the word line, and the potential variation appears on the bit line based on the data stored in the memory cell. And, when the sense amplifier control signal $\phi$SA is supplied, the potential of the sense amplifier activating signal supply line SLp is gradually charged from the potential HVcc toward the power supply potential Vcc. Thus, the potential level of the sense amplifier activating signal is gradually increased.

At this moment, the control signal $\phi$x becomes a High level, a Low level signal is supplied to the input of the inverter 1003, and the column decoder control signal $\overline{\phi CL}$ becomes a Low level. And, a desired column is selected by the column decoder 103, and a column selecting signal is supplied to the column line CLi of the selected column. The inverter 1003 outputs a High level column decoder control signal $\phi$CL in response to a Low level signal output from the inverter 1001.

Since one electrode of the PMOS 1005 of the inverter 1003 is connected to the sense amplifier activating signal supply line SLp in this case, a driving potential V1' supplied to the inverter rises with the potential increase of the sense amplifier activating signal supply line SLp. Therefore, the potential level of the column selecting signal supplied to the gates of the transfer gate TGi, $\overline{TGi}$ gradually rises.

In this arrangement, the potential of the sense amplifier activating signal supply line SLp goes up nearly to the power supply potential Vcc in the end. However, since the driving potential V1' is determined in correspondence with the potential variation of the sense amplifier activating signal for driving the sense amplifier which amplifies the potential difference between lines of the bit line pair, the arrangement of this embodiment also monitors the potential of the bit line, which is substantially equivalent to the foregoing described memory device.

That is, the timing at which the bit line is connected to the data bus is automatically set by the amplification rate of the potential of the bit line and the potential level of the column selecting signal (the potential level of the column line). Further, even in a case where a write operation time can be assumed to increase, the driving potential V1' supplied to each unit decoder of the column decoders rises finally to the level of the power supply potential Vcc and hence, a factor that may become an obstacle to the high speed operation is removed.

According to the arrangement of this embodiment, the following effect is further obtained in addition to various effects as described in the foregoing embodiments of the present invention.

In the semiconductor memory device to which the second type unit decoder is applied, the arrangement of this embodiment is realized by connecting the sense amplifier activating signal supply line SLp to the inverter that outputs the column decoder control signal $\phi$CL. Further, even in a case where a write operation time can be assumed to increase, as described above, this arrangement overcomes such an obstacle described hereinabove.

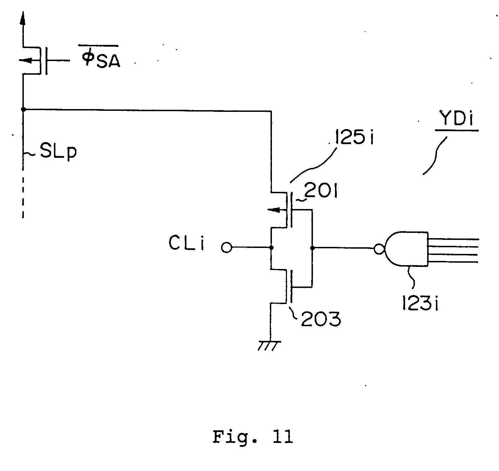

And, although the description was made with the case to which the second type unit decoder was applied, when the first type unit decoder is applied, the arrangement will become the one as illustrated in Fig. 11. This case is considered to be the same as the foregoing embodiment.

In this embodiment, one electrode of the NMOS 201 of the first unit decoder is connected to the sense amplifier activating signal supply line SLp. In this case, the more detailed description of the operation or the like will be omitted since it is considered to be understood easily with reference to the foregoing embodiments.

According to the arrangement of this embodiment, a DRAM circuit performing a high speed and reliable operation can be realized further easily. That is, since this arrangement is realized when the sense amplifier activating signal supply line Slp is connected to the inverter that outputs the column decoder control signal $\phi$CL, a very simple design modification of the current circuit brings about a high quality circuit without substantially increasing the manufacturing process. This is more advantageous to semiconductor manufacturers from the economic aspect.

The present invention has been described with reference to illustrative embodiments, however, this description must not be considered to be confined only to the embodiments illustrated. Various modifications and changes of these illustrative embodiments will become apparent to one skilled in the art from reference to the description of the present invention. It is therefore contemplated that the appended claims will cover any such modifications or embodiments as fall within the true scope of the invention.

INDUSTRIAL APPLICABILITY

As described above, a semiconductor memory circuit with a high speed and reliable operation can be realized by applying the present invention to a semiconductor memory device. Further, a very simple design modification can realize the circuit arrangement, so that a high quality semiconductor memory device can be formed without sacrificing a higher integration and complicating the production process.

**Claims**

**1.** A memory circuit (100) comprising:

a plurality of word lines (WL);
a plurality of bit line pairs (BL, $\overline{BL}$) arrayed so

as to intersect the word lines;

a plurality of memory cells (MC) connected at the intersections of the word lines and the bit line pairs, each of said memory cells storing data therein,

a sense amplifier (SA) for amplifying a potential of a line of the bit line pairs in response to a sense amplifier activating signal supplied from a sense amplifier activating signal supply line (SL);

a row decoder (101) for selecting a desired word line from the word lines in response to a row address signal (XADD);

a data bus (DB, $\overline{DB}$);

a plurality of transfer transistors (TG) each arrayed between each of the bit line pairs and the data bus, wherein each one electrode of the transfer transistors is connected to each of the bit line pairs, each of other electrode is connected to the data bus, and column selecting signals are supplied to control electrodes thereof;

a column decoder (103) for outputting the column selecting signals (CL) to the control electrodes of the transfer transistors in response to a column address signal (YADD); and

a power supply potential (Vcc) for driving each element and a reference potential (Vss) sufficiently lower than the power supply potential;

an inverter (125) having input and output terminals is arrayed in an output part (YD) of the column decoder, wherein the inverter consists of a first conductive MOS (201) transistor having first and second electrodes and a first control electrode, and a second conductive MOS (203) transistor having third and fourth electrodes and a second control electrode, the first and second control electrodes being connected to the input terminal, the first and third electrodes being connected to the output terminal, a driving potential (Vi) which is lower than the power supply potential and higher than the reference potential is supplied to the second electrode, and the reference potential is supplied to the fourth electrode, the memory circuit characterized in that the driving potential (Vi) is responsive to a potential of the sense amplifier activating signal supply line.

2. A memory circuit as claimed in claim 1, wherein the driving potential exceeds a potential corresponding to a threshold voltage of the transfer transistors, and does not exceed a potential obtained by adding the potential of the threshold voltage of half of the power supply potential.

3. A memory circuit as claimed in claim 2, wherein the driving potential is an intermediate potential between the power supply potential and the reference potential.

4. A memory circuit as claimed in claim 1, wherein the second electrode is connected to an output of a second inverter, the second inverter consisting of a first conductive MOS transistor having fifth and sixth electrodes and a second conductive MOS transistor having seventh and eighth electrodes, wherein the fifth and seventh electrodes are connected to the output of the second inverter, the sixth electrode is connected to the sense amplifier activating signal supply line, and the driving potential responds to a potential variation of the sense amplifier activating signal supply line when the reference potential is supplied to the eighth electrode.

**Patentansprüche**

1. Speicherschaltung (100), die folgendes aufweist:

eine Vielzahl von Wortleitungen (WL);

eine Vielzahl von Bitleitungspaaren (BL, $\overline{BL}$), die so angeordnet sind, daß sie die Wortleitungen schneiden;

eine Vielzahl von Speicherzellen (MC), die an den Schnittstellen der Wortleitungen und der Bitleitungspaare angeschlossen sind, wobei jede der Speicherzellen Daten darin speichert;

einen Leseverstärker (SA) zum Verstärken eines Potentials einer Leitung der Bitleitungspaare in Antwort auf ein Leseverstärkeraktivierungssignal, das von einer Leseverstärkeraktivierungssignal-Zufuhrleitung (SL) zugeführt wird;

einen Zeilendecodierer (101) zum Auswählen einer erwünschten Wortleitung aus den Wortleitungen in Antwort auf ein Zeilenadressensignal (XADD);

einen Datenbus (DB, $\overline{DB}$);

eine Vielzahl von Übertragungstransistoren (TG), die jeweils zwischen jedem der Bitleitungspaare und dem Datenbus angeordnet sind, wobei jede Elektrode der Übertragungstransistoren mit jedem der Bitleitungspaare verbunden ist, jede andere Elektrode mit dem Datenbus verbunden ist und Spaltenauswahlsignale zu ihren Steuerelektroden zugeführt werden;

einen Spaltendecodierer (103) zum Ausgeben der Spaltenauswahlsignale (CL) zu den Steuerelektroden der Übertragungstransistoren in Antwort auf ein Spaltenadressensignal (YADD); und

ein Leistungsversorgungspotential (Vcc) zum Treiben jedes Elements und ein Referenzpotential (Vss), das ausreichend niedriger als das Leistungsversorgungspotential ist;

einen Inverter (125) mit Eingangs- und Ausgangsanschlüssen, der in einem Ausgangsteil (YD) des Spaltendecodierers angeordnet ist, wobei der Inverter aus einem ersten leitenden MOS-(201)-Transistor mit einer ersten und einer zweiten Elektrode und einer ersten Steuerelektrode und einem zweiten leitenden MOS-(203)-Transistor mit einer dritten und einer vierten Elektrode und einer zweiten Steuerelektrode besteht, wobei die erste und die zweite Steuerelektrode an den Eingangsanschluß angeschlossen sind, wobei die erste und die dritte Elektrode an den Ausgangsanschluß angeschlossen sind, wobei ein Treiberpotential (Vi), das niedriger als das Leistungsversorgungspotential und höher als das Referenzpotential ist, zur zweiten Elektrode zugeführt wird und das Referenzpotential zur vierten Elektrode zugeführt wird, wobei die Speicherschaltung dadurch gekennzeichnet ist, daß das Treiberpotential (Vi) auf ein Potential der Leseverstärkeraktivierungssignal-Zufuhrleitung antwortet.

2. Speicherschaltung nach Anspruch 1, wobei das Treiberpotential ein Potential übersteigt, das einer Schwellenspannung der Übertragungstransistoren entspricht, und ein Potential nicht übersteigt, das durch Addieren des Potentials der Schwellenspannung zu einer Hälfte des Leistungsversorgungspotentials erhalten wird.

3. Speicherschaltung nach Anspruch 2, wobei das Treiberpotential ein Zwischenpotential zwischen dem Leistungsversorgungspotential und dem Referenzpotential ist.

4. Speicherschaltung nach Anspruch 1, wobei die zweite Elektrode an einen Ausgang eines zweiten Inverters angeschlossen ist, wobei der zweite Inverter aus einem ersten leitenden MOS-Transistor mit einer fünften und einer sechsten Elektrode und einem zweiten leitenden MOS-Transistor mit einer siebten und einer achten Elektrode besteht, wobei die fünfte und die siebte Elektrode an den Ausgang des zweiten Inverters angeschlossen sind, die sechste Elektrode an die Leseverstärkeraktivierungssignal-Zufuhrleitung angeschlossen ist und das Treiberpotential auf eine Potentialschwankung der Leseverstärkeraktivierungssignal-Zufuhrleitung antwortet, wenn das Referenzpotential zur achten Elektrode zugeführt wird.

**Revendications**

1. Circuit (100) de mémoire comprenant :

une pluralité de lignes (WL) de mots ;

une pluralité de paires (BL, $\overline{BL}$) de lignes de bits agencées de façon à couper les lignes de mots ;

une pluralité de cellules (MC) de mémoire connectées au niveau des intersections des lignes de mots et des paires de lignes de bits, chacune desdites cellules de mémoire y mémorisant une donnée ;

un amplificateur (SA) de lecture destiné à amplifier le potentiel d'une ligne de la paire de lignes de bits en réponse à un signal d'activation d'amplificateur de lecture délivré depuis une ligne (SL) de délivrance de signal d'activation d'amplificateur de lecture ;

un décodeur (101) de rangée destiné à sélectionner, parmi les lignes de mots, une ligne de mots voulue en réponse à un signal (XADD) d'adresse de rangée ;

un bus (DB, $\overline{BD}$) de données ;

une pluralité de transistors (TG) de transfert chacun agencé entre chacune des paires de lignes de bits et le bus de données, dans lequel chaque première électrode des transistors de transfert est connectée à chacune des paires de lignes de bits, chaque autre électrode est connectée au bus de donnée, et des signaux de sélection de colonne sont délivrés pour en commander les électrodes ;

un décodeur (103) de colonne destiné à sortir les signaux (CL) de sélection de colonne vers les électrodes de commande des transistors de transfert en réponse à un signal (YADD) d'adresse de colonne ; et

un potentiel (V$_{CC}$) d'alimentation destiné à attaquer chaque élément et un potentiel (V$_{SS}$) de référence suffisamment plus bas que le potentiel d'alimentation ;

un inverseur (125) ayant des bornes d'entrée et de sortie, qui est agencé dans une partie (YD) de sortie du décodeur de colonne, dans lequel l'inverseur est constitué d'un premier transistor MOS (à métal-oxyde-semi-conducteur) conducteur (201) ayant des première et deuxième électrodes et une première électrode de commande, et un second transistor MOS conducteur (203) ayant des troisième et quatrième électrodes et une seconde électrode de commande, les première et seconde électrodes de commande étant connectées à la borne d'entrée, les première et troisième électrodes étant connectées à la borne de sortie, un potentiel (V$_i$) d'attaque qui est plus bas que le potentiel d'alimentation et plus haut que le potentiel de référence étant délivré à la seconde électrode, et le potentiel de référence étant délivré à la quatrième électrode, le circuit de mémoire étant caractérisé en ce que le potentiel (V$_i$) d'attaque est sensible à un potentiel de la ligne de délivrance de signal d'activation d'amplificateur de lecture.

2. Circuit de mémoire selon la revendication 1, dans lequel le potentiel d'attaque excède un potentiel correspondant à une tension de seuil des transistors de transfert, et n'excède pas un potentiel obtenu en augmentant le potentiel de la tension de seuil de la moitié du potentiel d'alimentation.

3. Circuit de mémoire selon la revendication 2, dans lequel le potentiel d'attaque est un potentiel intermédiaire entre le potentiel d'alimentation et le potentiel de référence.

4. Circuit de mémoire selon la revendication 1, dans lequel la seconde électrode est connectée à une sortie d'un second inverseur, le second inverseur étant constitué d'un premier transistor MOS conducteur ayant des cinquième et sixième électrodes et à un second transistor MOS conducteur ayant des septième et huitième électrodes, dans lequel les cinquième et septième électrodes sont connectées à la sortie du second inverseur, la sixième électrode est connectée à la ligne de délivrance de signal d'activation d'amplificateur de lecture, et dans lequel le potentiel d'attaque réagit à une variation de potentiel de la ligne de délivrance de signal d'activation d'amplificateur de lecture lorsque le potentiel de référence est délivré à la huitième électrode.

Fig. 1

Fig. 2

Fig. 3

Fig. 4

Fig. 5

BL,$\overline{BL}$

CL

DB

Fig. 6

BL,$\overline{BL}$

X

CL

DB

Fig. 7

Fig. 8

EP 0 811 985 B1

Fig. 9

Fig. 10

17

Fig. 11